# DEMANDE DE BREVET EUROPEEN

(11) **EP 2 277 822 A1**
(43) Date de publication de la demande: **26.01.2011**
(21) Numéro de dépôt: 09166269.2
(22) Date de dépôt: 23.07.2009
(51) Int. Cl.: B81C 1/00

(54) **Procede de fabrication d'une piece micromecanique en silicium renforce**

(71) Demandeur: MONTRES BREGUET S.A., 1344 L'Abbaye (CH)
(72) Inventeur: Karapatis, Nakis, 1324, Premier (CH)
(74) Mandataire: Surmely, Gérard

(57) **Abrégé**

Le procédé de fabrication d'une pièce micromécanique en silicium renforcé comporte les étapes de :
- micro-usiner la pièce, ou un lot de pièces dans une plaquette de silicium ;
- former, sur toute la surface de la pièce, en une ou plusieurs étapes, une couche de dioxyde de silicium, de manière à obtenir une épaisseur de dioxyde de silicium au moins cinq fois supérieure à l'épaisseur d'un dioxyde de silicium natif ;
- retirer la couche de dioxyde de silicium par attaque chimique.

## Description

### DOMAINE TECHNIQUE

La présente invention concerne un procédé pour produire des pièces de micromécanique renforcées réalisées en silicium. Il s'agit d'un procédé de fabrication de pièces de micromécanique en silicium, qui confère à ces dernières une résistance mécanique, et notamment une résistance aux chocs, accrue ainsi que de bonnes propriétés tribologiques. La présente invention concerne plus particulièrement un tel procédé prévu pour être appliqué à des pièces de micromécanique agencées pour être en contact par frottement avec d'autres pièces relativement auxquelles elles sont en mouvement. Ces pièces de micromécanique peuvent être aussi bien des pièces mobiles, comme les pièces pivotées par exemple, que des pièces fixes, comme les paliers par exemple. Il s'agit par exemple, mais de façon non limitative, de pièces de micromécanique d'un mouvement horloger mécanique.

### ARRIERE PLAN TECHNOLOGIQUE

Le silicium est un matériau de plus en plus utilisé dans la fabrication de pièces mécaniques et notamment de pièces de micromécanique, qu'il s'agisse de pièces "captives", c'est-à-dire qui restent liées à un substrat sur lequel elles ont été usinées, ou de pièces "libres" telles que des pièces faisant partie de la chaîne cinématique d'un mouvement horloger.

Par rapport aux métaux ou alliages classiquement utilisés pour fabriquer des pièces de micromécaniques, telles que des roues dentées, des pièces articulées, ou des ressorts, le silicium présente l'avantage d'avoir une densité 3 à 4 fois plus faible et donc de présenter une inertie très réduite, et d'être insensible aux champs magnétiques. Ces avantages sont particulièrement intéressants dans le domaine horloger, tant en ce qui concerne l'isochronisme que la durée de marche.

Le silicium a toutefois, à juste titre, la réputation d'être sensible aux chocs, qui peuvent être nécessaires lors de l'assemblage, inévitables lors du fonctionnement, ou fortuits par exemple lorsque l'usager cogne, ou laisse tomber sa montre-bracelet.

Le document de brevet W02007/000271 propose un procédé pour améliorer la résistance mécanique des pièces de micromécanique en silicium. Selon ce document antérieur, une fois que les pièces ont été micro-usinées dans une plaquette de silicium, on recouvre leur surface d'une couche de dioxyde de silicium. Cette couche est formée par oxydation thermique de la surface de la pièce à une température comprise entre 900°C et 1200°C. La durée du processus d'oxydation thermique est déterminée de manière à obtenir une épaisseur de dioxyde de silicium au moins cinq fois supérieure à l'épaisseur du dioxyde de silicium natif.

Un inconvénient du procédé qui vient d'être décrit est que le dioxyde de silicium augmente sensiblement les coefficients de frottement des pièces obtenues. Pour remédier à cet inconvénient, le document susmentionné propose d'ajouter un revêtement en un autre matériau sur le dioxyde de silicium amorphe ; ce dernier matériau devant être choisi pour ses propriétés tribologiques. Cette solution qui consiste à ajouter un revêtement supplémentaire par-dessus la couche de dioxyde de silicium présente l'inconvénient de multiplier les couches de revêtement. De plus, certains revêtements n'adhèrent pas bien sur le dioxyde de silicium.

### RESUME DE L'INVENTION

La présente invention vise donc à fournir un procédé de fabrication de pièces de micromécanique en silicium, qui confère à ces dernières une résistance mécanique comparable à celle des pièces produites selon le procédé du document W02007/000271, tout en leur donnant également des propriétés tribologiques comparables à celles de pièces en silicium n'ayant pas été revêtues dune couche de dioxyde de silicium.

A cet effet l'invention concerne un procédé de fabrication d'une pièce en silicium renforcé selon la revendication 1 annexée.

De manière étonnante *a priori,* l'expérience montre que l'étape selon l'invention d'éliminer la couche de dioxyde de silicium n'affecte pratiquement pas les propriétés mécaniques de ladite pièce. Autrement dit, la résistance mécanique des pièces produites selon la présente invention est pratiquement la même que celle des pièces produites selon le procédé du document W02007/000271 déjà mentionné. De plus, les propriétés tribologiques des pièces produites selon la présente invention sont sensiblement meilleures.

Sans qu'aucune des hypothèses avancées ci-dessous n'aient un caractère limitatif, on peut tenter l'explication suivante :
Tout d'abord, lorsqu'on forme la couche de dioxyde de silicium sur la surface de la pièce, le dioxyde ne se contente pas exclusivement de recouvrir l'extérieur de la pièce. Il remplit et colmate également les fissures, les brèches et les autres micro-ouvertures dans le silicium. Comme, du point de vue chimique, un atome de silicium a plus d'affinité pour un atome d'oxygène que pour un autre atome de silicium, les jonctions silicium-dioxyde devraient avoir une grande adhérence et le dioxyde de silicium constituer une soudure très efficace des défauts du silicium.

Lorsqu'on retire la couche de dioxyde de silicium, le « stripping » se fait naturellement à partir de l'extérieur. Ainsi, le dioxyde à l'intérieur de micro-ouvertures dans de silicium est le dernier à être attaqué. On comprendra donc que, lorsque la couche de dioxyde de silicium a été retirée, il devrait subsister un certain nombre de veines ou d'inserts de dioxyde comblant des micro-ouvertures dans la surface de la pièce en silicium. La présence de ces « soudures » en dioxyde pourrait être responsable du renforcement du silicium, et donc de la plus grande résistance mécanique des pièces réalisées.

Selon une variante avantageuse du procédé de la présente invention, la couche de dioxyde de silicium est formée par oxydation thermique de la surface de la pièce à une température comprise entre 900°C et 1200°C. On comprendra que selon cette variante, la réaction produisant le dioxyde consomme du silicium. Ainsi, au fur et à mesure de l'étape d'oxydation, la surface du silicium qui constitue l'interface avec la nouvelle couche de dioxyde recule. Le recul de la surface du silicium présente l'avantage de faire disparaître les fissures superficielles les moins profondes ainsi que d'autres micro-ouvertures dans le silicium sans qu'il ne soit nécessaire de les colmater.

### BREVE DESCRIPTION DES DESSINS

D'autres caractéristiques et avantages de la présente invention apparaîtront plus clairement dans la description qui suit d'un exemple de réalisation, donné à titre illustratif et non limitatif, en référence aux dessins annexés dans lesquels:
- la figure 1a représente la section initiale d'une pièce de micromécanique en silicium ;
- la figure 2a correspond à la figure 1a après formation d'une couche de dioxyde de silicium ;
- la figure 3a correspond à la figure 2a après élimination de la couche de dioxyde de silicium ;

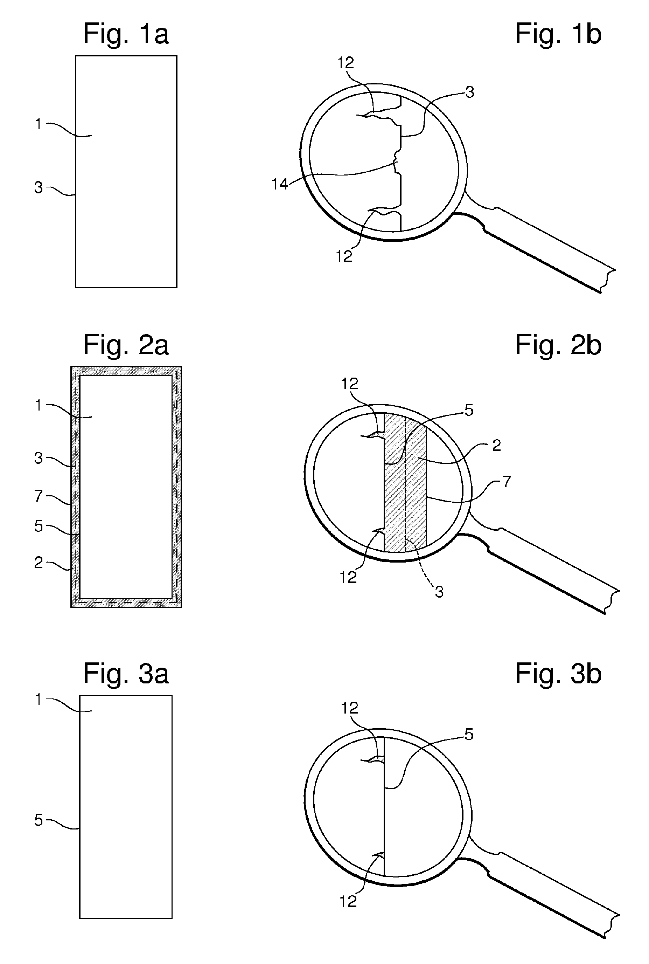

- la figure 1b est un fort agrandissement d'une partie de la figure 1a montrant deux microfissures et une micro-ouverture dans la surface du silicium ;
- la figure 2b correspond à la figure 1b après formation d'une couche de dioxyde de silicium ; et
- la figure 3b correspond à la figure 2b après élimination de la couche de dioxyde de silicium.

### DESCRIPTION DETAILLEE DE L'INVENTION

Comme exemple de pièces de micromécanique renforcées pouvant être réalisées grâce au procédé de l'invention, on peut citer les roues dentées, les roues d'échappement, les ancres ou encore d'autres pièces pivotées comme les arbres. Enfin, le procédé de la présente invention permet également de réaliser des pièces passives comme par exemple des paliers.
La figure 1a représente de manière tout à fait schématisée la section d'une pièce de micromécanique ayant une âme 1 en silicium, la référence 3 désignant la surface extérieure initiale. Lorsque la pièce en silicium est abandonnée un certain temps au milieu ambiant, elle se recouvre naturellement de dioxyde de silicium dit "oxyde natif" (non représenté) dont l'épaisseur est sensiblement comprise entre 1 et 10 nm. La figure 1b est un fort agrandissement d'une partie de la figure 1a montrant deux microfissures 12 et une micro-ouverture superficielle 14 dans la surface 3 du silicium. Il est raisonnable de penser que la présence de telles fissures ou micro-ouvertures peut contribuer à rendre la pièce en silicium plus fragile et cassante.
La figure 2a représente la section de la figure 1a après la formation d'une couche d'oxyde de silicium par oxydation thermique de la surface de la pièce en silicium entre 900°C et 1200°C. A cet effet on applique le protocole décrit dans l'ouvrage "Semiconductors devices : physics and technology (éds John Wiley & sons, ISBN 0-471-87424-8, 01.01 1985, p. 341-355). Ainsi, il faut environ 10h à une température de 1100°C pour obtenir une épaisseur de SiO₂ d'environ 1,9 µm. Comme on le voit sur la figure 2a, le dioxyde se forme au détriment du silicium dont le front 3 recule pour créer une nouvelle interface 5 avec le SiO₂ formé. Inversement, étant donné que SiO₂ a une densité plus faible, la surface extérieure 7 de SiO₂ s'étend au-delà de la surface initiale de la pièce. Les positions de ces lignes de démarcation 3, 5 et 7 ne sont pas représentées à l'échelle. La figure 2b montre le même agrandissement que la figure 1b après formation de la couche de dioxyde de silicium. On voit que la micro-ouverture superficielle 14 a entièrement disparu en raison du recul de l'interface 5 entre le silicium et le SiO₂ formé. On voit également que les microfissures 12 ont été entièrement colmatées par le dioxyde de silicium.
La figure 3a représente la même section de la pièce en silicium après que la couche de dioxyde de silicium ait été retirée par attaque chimique à l'aide d'une solution d'acide fluorhydrique. La couche de SiO₂ ayant été éliminée par le traitement, on voit que la limite 5, qui sur la figure 2 correspondait à l'interface entre le silicium et l'oxyde, est maintenant devenue la surface extérieure. Comme l'oxydation a consommé une partie du silicium, les dimensions de la pièce de micro-mécanique fournie par le procédé de l'invention sont légèrement inférieures aux dimensions qui lui ont été données lors du micro-usinage. Toutefois, il est bien évident que la connaissance des propriétés physiques de Si et SiO₂ et des caractéristiques du traitement thermique permet de calculer les cotes initiales pour découper la pièce pour avoir en fin de ce traitement les cotes voulues. La figure 3b montre le même agrandissement que les figures 1b et 2b après élimination de la couche 2 de dioxyde de silicium. On voit que des « veines » de dioxyde de silicium subsiste à l'intérieur des microfissures 12. De manière à réduire au minimum l'érosion du dioxyde à l'intérieur des microfissures, l'étape de « stripping » du dioxyde de silicium devrait de préférence être interrompue dès que la couche 2 a été éliminée. La connaissance des propriétés chimiques du SiO₂ ainsi que de l'acide fluorhydrique dilué employé pour le « stripping » permet de calculer un temps d'exposition optimal de manière à éliminer la couche de SiO₂ tout en conservant les veines de dioxyde dans les fissures 12. Comme déjà mentionné, un atome de silicium a plus d'affinité pour un atome d'oxygène que pour un autre atome de silicium. Dans ces conditions, le colmatage des microfissures par un filet de dioxyde de silicium pourrait être le responsable de la bonne résistance mécanique observée avec les pièces produites par le procédé de la présente invention.

L'homme du métier comprendra d'autre part que le recul de la surface du silicium lors de la formation de la couche de dioxyde est causé par l'oxydation thermique. En formant la couche de dioxyde par un autre procédé, par exemple à partir de silane (SiH₄) ou de TEOS (Si(OC₂H₅)₄), il serait en principe possible de mettre en oeuvre le procédé de la présente invention tout en évitant le rétrécissement des pièces qui vient d'être décrit.

On comprendra en outre que diverses modifications et/ou améliorations évidentes pour un homme du métier peuvent être apportées au mode de mise en oeuvre qui fait l'objet de la présente description sans sortir du cadre de la présente invention définie par les revendications annexées. En particulier, l'acide fluorhydrique en solution n'est pas le seul moyen d'éliminer la couche de dioxyde de silicium. L'homme du métier pourra utiliser tout moyen qui lui paraîtra adéquat pour réaliser cet opération, notamment utiliser du BHF.

D'autre part, selon une variante non représentée du procédé de l'invention, une étape supplémentaire peut être prévue dans laquelle un revêtement réalisé en un matériau choisi pour ses propriétés tribologiques est formé sur la surface en silicium après que le SiO₂ ait été éliminé. A cet effet, l'homme du métier pourra choisir tout matériau qui lui paraîtra convenir. Il pourra notamment choisir du carbone cristallisé sous forme de diamant (DLC) ou des nanotubes de carbone.

## Revendications

1. Procédé de fabrication d'une pièce micromécanique en silicium renforcé, ledit procédé comportant, dans l'ordre, les étapes consistant à :
- micro-usiner la pièce, ou un lot de pièces dans une plaquette de silicium ;
- former, sur toute la surface de la pièce, en une ou plusieurs étapes, une couche de dioxyde de silicium, de manière à obtenir une épaisseur de dioxyde de silicium au moins cinq fois supérieure à l'épaisseur d'un dioxyde de silicium natif ;
- retirer la couche de dioxyde de silicium par attaque chimique.

2. Procédé selon la revendication 1, **caractérisé en ce que** l'épaisseur de la couche de dioxyde de silicium est au moins cent fois supérieure à l'épaisseur du dioxyde de silicium natif.

3. Procédé selon la revendication 1, **caractérisé en ce que** la couche de dioxyde de silicium est formée par oxydation thermique de la surface de la pièce à une température comprise entre 900°C et 1200°C.

4. Procédé selon la revendication 2, **caractérisé en ce que**, dans la première étape du procédé, la pièce est micro-usinée avec des cotes légèrement supérieures aux cotes finales souhaitées, et **en ce qu'**ensuite la couche de dioxyde de silicium est formée par oxydation thermique de la surface de la pièce à une température comprise entre 900°C et 1200°C.

5. Procédé selon l'une des revendications précédentes, **caractérisé en ce qu'**il comprend, après l'étape de retirer la couche de dioxyde de silicium, une étape de former sur la surface de la pièce un revêtement en un matériau ayant des propriétés tribologiques supérieures à celles du silicium cristallin.

6. Pièce de micromécanique en silicium renforcé destinée à être intégrée dans un mécanisme horloger, **caractérisée en ce qu'**elle est susceptible d'être obtenue par le procédé selon l'une des revendications 1 à 5.

7. Pièce selon la revendication 6, **caractérisée en ce que** des « veines » de dioxyde de silicium sont présentes dans la surface de la pièce.
